# EUROPÄISCHE PATENTANMELDUNG

(11) **EP 2 498 296 A1**
(43) Veröffentlichungstag der Anmeldung: **12.09.2012**
(21) Anmeldenummer: 11157475.2
(22) Anmeldetag: 09.03.2011
(51) Int. Cl.: H01L 31/0224, H01L 31/18

(54) **Verfahren zur Erzeugung von elektrisch leitfähigen Kontaktstrukturen auf einer Substratoberfläche**

(71) Anmelder: Deutsche Solar AG, 09599 Freiberg (DE)
(72) Erfinder: Rolle, André, 09599, Freiberg (DE); Dr. Neuhaus, Holger, 09599, Freiberg (DE); Weber, Torsten, 01097, Dresden (DE); Schneiderlöchner, Eric, 09599, Freiberg (DE); Schlegel, Kristian, 08056, Zwickau (DE); Pethe, Wieland, 01099, Dresden (DE); Richter, Philipp, 09599, Freiberg (DE)
(74) Vertreter: Viering, Jentschura & Partner

(57) **Zusammenfassung**

Die vorliegende Erfindung betrifft ein Verfahren zur Erzeugung von elektrisch leitfähigen Strukturen auf einem Substrat, das eine dielektrische Oberflächenschicht (101) und eine darunter liegende elektrisch leitfähige Schicht (102) aufweist, wobei das Verfahren das Aufbringen einer ersten metallhaltigen Zusammensetzung (104), die ein Ätzmittel und ein Metall oder Metallsalz enthält, auf zwei voneinander beabstandete Teilbereiche der Oberfläche der dielektrischen Schicht (101); das Aufbringen einer zweiten metallhaltigen Zusammensetzung (105), die ein Metall oder Metallsalz enthält, auf einen Teil der Oberfläche der dielektrischen Schicht (101), wobei die Aufbringung derart erfolgt, dass die zwei voneinander beabstandete Teilbereiche der Oberfläche der dielektrischen Schicht (101), die mit der ersten metallhaltigen Zusammensetzung (104) beschichtet sind, durch die zweite metallhaltige Zusammensetzung (105) verbunden werden; und das Erhitzen des Substrates um elektrisch leitfähige Strukturen auf dem Substrat zu erzeugen und einen elektrischen Kontakt zwischen den elektrisch leitfähigen Strukturen und der Leiter- oder Halbleiterschicht herzustellen, umfasst. Ferner betrifft die Erfindung die durch dieses Verfahren erhaltenen elektrisch leitfähigen Strukturen sowie Solarzellen und Solarmodule, die diese Strukturen enthalten.

## Beschreibung

### Gebiet der Erfindung

Die vorliegende Erfindung betrifft ein Verfahren zur Erzeugung von elektrisch leitfähigen Strukturen auf einem Substrat, das eine dielektrische Schicht und eine darunter liegende elektrisch leitfähige Schicht aufweist, insbesondere einer Solarzelle oder einem Solarmodul. Die leitfähigen Strukturen werden mittels einer ersten und einer zweiten metallhaltigen Zusammensetzung, wobei die erste metallhaltige Zusammensetzung ferner ein Ätzmittel umfasst, erzeugt. Ferner betrifft die Erfindung die durch dieses Verfahren erhaltenen elektrisch leitfähigen Strukturen sowie Solarzellen und Solarmodule, die diese Strukturen enthalten.

### Hintergrund

Solarzellen müssen in Solarmodulen seriell durch Auflöten von Kupferbändchen verschaltet werden. Dazu werden auf Solarzellen üblicherweise Kontaktstrukturen aus Metallen wie Silber z. B. durch Siebdruckprozesse aufgebracht und in einem Hochtemperaturschritt eingebrannt. Die Metalle werden dabei üblicherweise in Form einer Paste auf die antireflexionsbeschichtete und/oder passivierte Oberfläche der Solarzelle gedruckt und dann durch Erhitzen durch die Oberflächenschicht durchgefeuert, um einen elektrischen Kontakt mit der darunter liegenden Halbleiterschicht herzustellen.

Da es für den Wirkungsgrad der Solarzelle vorteilhaft ist, wenn der Bereich der Oberfläche, der durch die Kontaktstrukturen abgedeckt wird, möglichst klein ist, werden die Kontakte üblicherweise in Form eines Kontaktbandes (Sammelleitung) mit vielen Kontaktfingern (Verbindungsleitungen) aufgebracht.

Die Kontaktbänder und -finger werden gewöhnlich durch eine Silberpaste ausgebildet, die in einem Druckverfahren auf die Oberfläche aufgebracht und dann durch die Passivierungsschicht durchgefeuert wird. Zu diesem Zweck enthält die Silberpaste üblicherweise ein Ätzmittel, das es erlaubt die Passivierungsschicht aufzuschmelzen und den Kontakt der sich ausbildenden Silberkontaktstruktur mit der darunter liegenden Halbleiterschicht herzustellen.

Aus dem Stand der Technik ist es bekannt, die Kontaktstrukturen auf der Oberfläche der Solarzelle in einem zweistufigen Prozess aufzudrucken, beispielsweise in einem ersten Schritt die Kontaktbänder und in einem zweiten Schritt die Kontaktfinger, bzw. umgekehrt (US 5,726,065; DE 20 2009 017 372 U1).

Nachteilig an den bekannten Verfahren ist, dass beim Durchfeuern der Antireflexions- und Passivierungsschicht zur Herstellung der Kontakte mit der darunter liegenden Halbleiterschicht die Oberflächenpassivierung im Bereich der Kontaktstrukturen zerstört wird, was zu einem erheblichen Anstieg des Sättigungsstromes führt und damit zur Verminderung des Wirkungsgrades.

Es ist bekannt, dass dieser Nachteil dadurch überwunden werden kann, dass ein Laser verwendet wird, der punktförmige Öffnung in die Passivierungsschicht einbringt, in die dann in einem nachfolgenden Metallisierungsverfahren eine Kontaktstruktur eingebracht wird (DE 10 2008 024 053 A1). Die Erzeugung von lokal begrenzten punktförmigen Öffnungen in der Passivierungsschicht, die zur Ausbildung von elektrischen Kontakten zu der Halbleiterschicht dienen, vermeidet die Zerstörung der Passivierungsschicht im gesamten Bereich der auf der Oberfläche der Solarzelle aufgebrachten elektrisch leitfähigen Strukturen, d.h. den elektrischen Leitungen, und begrenzt die Zerstörung der Passivierungsschicht auf die punktförmigen Kontaktstellen. Obwohl ein solches Verfahren die genannten Nachteile überwindet, ist der Einsatz eines Lasers vergleichsweise teuer.

Auf der Unterseite der Solarzelle ist üblicherweise eine durchgehende Metallschicht, üblicherweise eine Aluminiumschicht, als Kontakt vorhanden. Diese wird üblicherweise ganzflächig mittels geeigneter Verfahren auf die passivierte Rückseite aufgebracht und dann über Kontakte mit der darunter liegenden Basisschicht verbunden. Bei den sogenannten LFC (laser fired contacts) Zellen wird der Kontakt der Metallschicht mit der darunter liegenden Basisschicht durch das Durchfeuern durch die Passivierungsschicht mit einem geeigneten Laser erzielt. Dieses Verfahren hat dieselben Nachteile wie das oben für die Vorderseite der Solarzelle beschriebene Verfahren.

Wünschenswert sind daher alternative Verfahren zur Erzeugung von elektrisch leitfähigen Strukturen auf Substratoberflächen, insbesondere der Antireflexions- und Passivierungsschicht auf der Oberseite sowie der Passivierungsschicht auf der Unterseite einer Solarzelle, und der elektrischen Kontakte zu der Halbleiterschicht die zum einen die Nachteile die beim Durchfeuern der Antireflexionsschicht mittels geeigneter metallhaltiger Pasten auftreten und zum anderen die hohen Kosten die mit dem Einsatz eines Lasers verbunden sind vermeiden.

### Zusammenfassung der Erfindung

Die vorliegende Erfindung betrifft ein Verfahren zur Erzeugung von elektrisch leitfähigen Strukturen auf einem Substrat, das eine dielektrische Oberflächenschicht und eine darunter liegende elektrisch leitfähige Schicht aufweist, umfassend:
Aufbringen einer ersten metallhaltigen Zusammensetzung, die ein Ätzmittel und ein Metall oder Metallsalz enthält, auf mindestens zwei voneinander beabstandete Teilbereiche der Oberfläche der dielektrischen Schicht;
Aufbringen einer zweiten metallhaltigen Zusammensetzung, die ein Metall oder Metallsalz enthält, auf einen Teil der Oberfläche der dielektrischen Schicht, wobei die Aufbringung derart erfolgt, dass die mindestens zwei voneinander beabstandeten Teilbereiche der Oberfläche der dielektrischen Schicht, die mit der ersten metallhaltigen Zusammensetzung beschichtet sind, durch die zweite metallhaltige Zusammensetzung verbunden werden;
Erhitzen des Substrates um elektrisch leitfähige Strukturen auf dem Substrat zu erzeugen und einen elektrischen Kontakt zwischen den elektrisch leitfähigen Strukturen und der elektrisch leitfähigen Schicht herzustellen, wobei das Erhitzen nach dem Aufbringen der ersten metallhaltigen Zusammensetzung, nach dem Aufbringen der ersten und zweiten metallhaltigen Zusammensetzung oder jeweils nach dem Aufbringen der ersten und nach dem Aufbringen der zweiten metallhaltigen Zusammensetzung erfolgt.

In verschiedenen Ausführungsformen der Erfindung wird die erste metallhaltige Zusammensetzung punktuell auf die dielektrische Schicht aufgebracht. In verschiedenen Ausführungsformen beträgt der Durchmesser der derart beschichteten, vorzugsweise kreisförmigen, Bereiche etwa 30- 200 µm, vorzugsweise 50 - 100 µm. Die Zahl der Teilbereiche der Oberfläche auf die die erste metallhaltige Zusammensetzung aufgebracht wird ist mindestens zwei, liegt aber für handelsübliche Solarzellen üblicherweise im Bereich von 1000 - 200000.

In verschiedenen Ausführungsformen des erfindungsgemäßen Verfahrens, wird die zweite metallhaltige Zusammensetzung streifenförmig auf die dielektrische Schicht aufgebracht. Die derart aufgebrachten Streifen können beispielsweise eine Breite von 50 - 200 µm, vorzugsweise 100 - 120 µm haben. In speziellen Ausführungsformen verbinden diese Streifen mindestens 10, vorzugsweise mindestens 25, noch bevorzugter mindestens 50 mit der ersten metallhaltigen Zusammensetzung beschichtete Teilbereiche.

Alternativ kann die zweite metallhaltige Zusammensetzung auch ganzflächig auf die dielektrische Schicht und die erste metallhaltige Zusammensetzung aufgebracht werden. Bei der ganzflächigen Aufbringung können allerdings einzelne Teilbereich der Oberfläche ausgespart werden.

Das Aufbringen der ersten metallhaltigen Zusammensetzung und/oder der zweiten metallhaltigen Zusammensetzung kann mittels Drucken, insbesondere mittels Siebdruck- oder Tintenstrahldruckverfahren, Extrusionsverfahren, Stempeldruckverfahren, Tampondruckverfahren oder berührungsloses Verfahren, erfolgen. In verschiedenen Ausführungsformen der Erfindung kann das Aufbringen der zweiten metallhaltigen Zusammensetzung auch mittels Gasphasenabscheidung, zum Beispiel physikalischer Gasphasenabscheidung (PVD) oder chemischer Gasphasenabscheidung (CVD) inklusive plasma-gestützter Verfahren, und Sputtern erfolgen.

In verschiedenen Ausführungsformen der Erfindung, handelt es sich bei dem Substrat um eine Solarzelle. Dabei kann die dielektrische Schicht eine auf der Oberfläche der Solarzelle liegende Passivierungs- und Antireflexionsschicht sein. Diese kann aus Siliziumoxid, Siliziumcarbid, Siliziumnitrid, Titanoxid, Magnesiumfluorid oder Mischungen davon bestehen. Bei der unter der dielektrischen Schicht liegenden elektrisch leitfähigen Schicht, kann es sich um einen Emitter handeln. Der Emitter ist im Fall einer Silizium-Solarzelle vom n-Typ p-dotiert. Die dielektrische Schicht kann auch eine auf der Oberfläche der Unterseite einer Solarzelle liegende Passivierungsschicht sein. Diese kann ebenfalls aus Siliziumoxid, Siliziumcarbid, Siliziumnitrid, aber auch aus Aluminiumoxid oder anderen Metalloxide und/oder Halbmetall- oder Halbleiteroxiden sowie Mischungen davon bestehen. Bei der unter der dielektrischen Schicht liegenden elektrisch leitfähigen Schicht, kann es sich dann um die Si-Basisschicht handeln.

In verschiedenen Ausführungsformen der Erfindung enthält die zweite metallhaltige Zusammensetzung kein Ätzmittel, d.h. keinen Bestandteil, der beim Erhitzen die Passivierungsschicht zerstört.

In verschiedenen Ausführungsformen der Erfindung wird das Ätzmittel der ersten metallhaltigen Zusammensetzung ausgewählt wird aus Glasfritte, NH₄F, NH₄HF₂, H₃PO₄, H₃PO₃, PCl₃, PCl₅, POCl₃, KOH, HF/HNO₃, HCl, Chlorverbindungen, Schwefelsäure und Mischungen davon. Falls das Ätzmittel Glasfritte umfasst, kann die Glasfritte Bleioxid enthalten.

In verschiedenen Ausführungsformen der Erfindung enthalten die erste metallhaltige Zusammensetzung und/oder die zweite metallhaltige Zusammensetzung ein Metall ausgewählt aus der Gruppe bestehend aus Silber, Kupfer, Aluminium, Gold, Wolfram, Nickel, Vanadium, Chrom, Cobalt, Ruthenium, Rhodium, Palladium, Zinn und deren Legierungen oder ein Salz davon. Die erste metallhaltige Zusammensetzung kann ferner zur besseren Ausbildung der elektrischen Kontakte mit einem weiteren Element, wie beispielsweise Bor oder Phosphor, dotiert sein.

Die erste metallhaltige Zusammensetzung und/oder die zweite metallhaltige Zusammensetzung können ferner Bindemittel und/oder Lösungsmittel enthalten. Diese dienen beispielsweise dazu die Verarbeitbarkeit der Zusammensetzung sicherzustellen. Vorzugsweise liegen die Zusammensetzungen in Form von Pasten, Gelen, Lösungen oder Kolloiden, beispielsweise Suspensionen oder Emulsionen, vor. Bindemittel und/oder Lösungsmittel werden in Abhängigkeit von der gewünschten Form gewählt.

In verschiedenen Ausführungsformen erfolgt das Erhitzen des Substrats bei einer Temperatur von 500 bis 900 °C erfolgt. Das Erhitzen kann in einem Ofen erfolgen. Erhitzen kann für einen Zeitraum von 1 bis 30 s erfolgen.

Die vorliegende Erfindung betrifft ferner elektrisch leitfähige Kontaktstrukturen die durch ein Verfahren der Erfindung erhältlich sind sowie Solarzellen oder Solarmodule, die die derart hergestellten Kontaktstrukturen umfassen.

### Beschreibung der Figuren

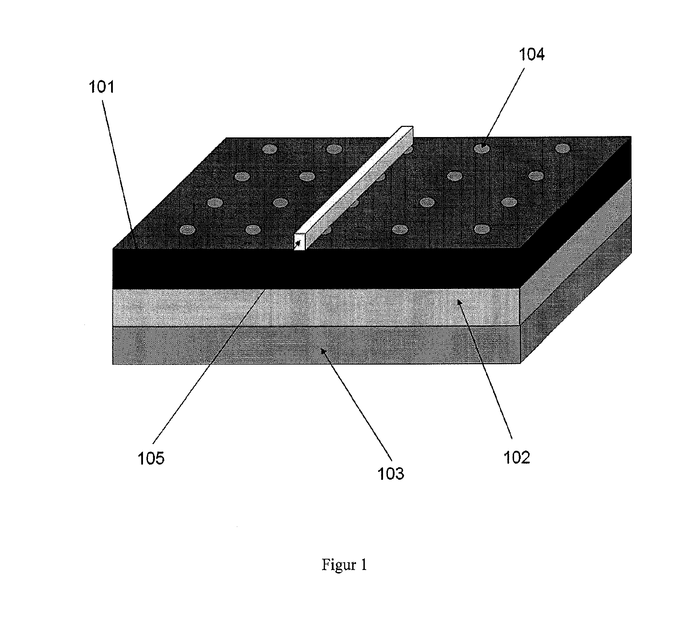

Figur 1 zeigt schematisch den Aufbau einer Solarzelle mit einer Basisschicht (103), der darüber liegenden Emitter-Schicht (102) und der zuoberst liegenden Antireflexions- und Passivierungsschicht (101) auf die punktuell die erste metallhaltige Zusammensetzung (104) und streifenförmig die zweite metallhaltige Zusammensetzung (105) aufgebracht ist. Aus Gründen der Einfachheit der Darstellung ist nur schematisch ein Ausschnitt der Oberfläche gezeigt. In der schematischen Darstellung ist ferner die zweite metallhaltige Zusammensetzung erst teilweise aufgebracht worden.

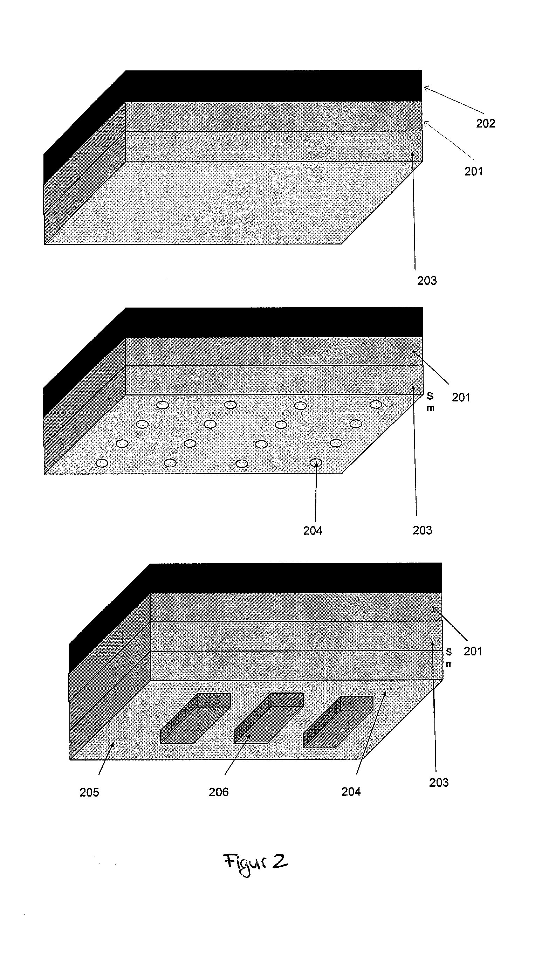

Figur 2 zeigt schematisch den Aufbau einer Solarzelle mit einer Basis- und Emitterschicht (201), der darüber liegenden Antireflexions- und Passivierungsschicht (202) und einer darunter liegenden Rückseitenpassivierungsschicht (203) auf die punktuell die erste metallhaltige Zusammensetzung (204) und ganzflächig die zweite metallhaltige Zusammensetzung (205) aufgebracht ist. Optional kann noch die Auftragung einer lötfähigen Paste in Form von Pads (206) erfolgen. Aus Gründen der Einfachheit der Darstellung ist nur schematisch ein Ausschnitt der Oberfläche gezeigt.

### Detaillierte Beschreibung der Erfindung

Der Erfindung liegt die Erkenntnis zugrunde, dass bei der Erstellung elektrisch leitender Strukturen auf der Oberfläche von Solarzellen das Durchfeuern der elektrischen Kontakte bei erhöhter Temperatur die Passivierungs- und Antireflexionsschicht zerstört, da die aufgedruckten metallhaltigen Pasten nicht nur punktuell sondern im gesamten Auftragungsbereich die Passivierungs- und Antireflexionsschicht aufschmelzen. Die Erfinder haben nun herausgefunden, dass dieses Problem dadurch umgangen werden kann, dass für das Erstellen der elektrisch leitfähigen Strukturen zwei verschiedene metallhaltige Zusammensetzungen verwendet werden, wobei die eine zum Durchfeuern durch die Passivierungsschicht geeignet ist und daher nur punktuell an den späteren Kontaktstellen aufgetragen wird, wohingegen die zweite nicht durch die Passivierungsschicht durchfeuert, sondern auf dieser elektrische Leitungen bildet, die die Kontakte miteinander verbinden.

In einem ersten Aspekt betrifft die Erfindung daher ein Verfahren zur Erzeugung von elektrisch leitfähigen Strukturen auf einem Substrat, das eine dielektrische Oberflächenschicht und eine darunter liegende elektrisch leitfähige Schicht aufweist, umfassend:
Aufbringen einer ersten metallhaltigen Zusammensetzung, die ein Ätzmittel und ein Metall oder Metallsalz enthält, auf mindestens zwei voneinander beabstandete Teilbereiche der Oberfläche der dielektrischen Schicht;
Aufbringen einer zweiten metallhaltigen Zusammensetzung, die ein Metall oder Metallsalz enthält, auf einen Teil der Oberfläche der dielektrischen Schicht, wobei die Aufbringung derart erfolgt, dass die mindestens zwei voneinander beabstandeten Teilbereiche der Oberfläche der dielektrischen Schicht, die mit der ersten metallhaltigen Zusammensetzung beschichtet sind, durch die zweite metallhaltige Zusammensetzung verbunden werden;
Erhitzen des Substrates um elektrisch leitfähige Strukturen auf dem Substrat zu erzeugen und einen elektrischen Kontakt zwischen den elektrisch leitfähigen Strukturen und der elektrisch leitfähigen Schicht herzustellen, wobei das Erhitzen nach dem Aufbringen der ersten metallhaltigen Zusammensetzung, nach dem Aufbringen der ersten und zweiten metallhaltigen Zusammensetzung oder nach dem Aufbringen der ersten und nach dem Aufbringen der zweiten metallhaltigen Zusammensetzung erfolgt.

Der Begriff "elektrisch leitfähigen Strukturen", wie er in diesem Zusammenhang verwendet wird, erfasst sowohl elektrischen Leitungen auf der Substratoberfläche als auch die elektrischen Kontakte zwischen Leiter- oder Halbleiterschicht und auf der Oberfläche liegender Leitung.

"Elektrisch leitfähige Schicht" bezieht sich auf eine Schicht aus einem Material, das den elektrischen Strom leitet, wie z. B. ein Metall, aber umfasst auch eine Schicht aus einem Halbleitermaterial, das unter bestimmten Bedingungen den elektrischen Strom leitet, wie beispielsweise Silizium.

"Dielektrisch", wie hierin verwendet, bezieht sich auf eine elektrisch schwach- oder nichtleitende Substanz. Beispielse für solche nichtleitenden Materialien sind Siliziumnitrid, Siliziumcarbid, Siliziumoxid, Aluminiumoxid und andere Metall- oder Halbmetalloxide sowie Mischungen der vorgenannten. Die Erfindung ist aber nicht auf diese Materialien beschränkt.

"Ätzmittel", wie hierin verwendet, bezieht sich auf jede Verbindung oder Zusammensetzung, die unter den Brennbedingungen geeignet ist durch die dielektrische Schicht durchzufeuern und Kontakt mit der darunter liegenden Leiter- oder Halbleiterschicht herzustellen. Dabei kann das Ätzmittel die dielektrische Schicht chemisch verändern, beispielsweise auflösen. In anderen Ausführungsformen ist das Ätzmittel dazu geeignet, unter Brennbedingungen die dielektrische Schicht aufzuschmelzen. Beispiele für Ätzmittel sind Glasfritte, NH₄F, NH₄HF₂, H₃PO₄, H₃PO₃, PCl₃, PCl₅, POCl₃, KOH, HF/HNO₃, HCl, Chlorverbindungen, Schwefelsäure und Mischungen davon. Glasfritte können Bleioxid enthalten. Der Begriff "Glasfritte" bezieht sich auf den Werkstoff, der bei dem oberflächlichen Schmelzen von Glaspulver, wobei die Glaspartikel zusammenbacken, entsteht. Dieser kann beispielsweise zu einem Pulver vermahlen sein.

"Erhitzen" bezieht sich auf das Aussetzen des Substrats mit der ersten und optional auch der zweiten metallhaltigen Zusammensetzung einer erhöhten Temperatur, üblicherweise 450-1200 °C, vorzugsweise 500-900 °C, beispielsweise in einem Ofen. Der Brennprozess dauert üblicherweise nur wenige Sekunden, beispielsweise 1 - 30 Sekunden, kann aber auch mehrere Minuten, z.B. 1-5 Minuten dauern. Das Erhitzen kann nach der Aufbringung der ersten metallhaltigen Zusammensetzung und ein zweites Mal nach Aufbringung der zweiten metallhaltigen Zusammensetzung erfolgen. Bevorzugt ist aber das Erhitzen nach Aufbringung der ersten und zweiten metallhaltigen Zusammensetzung. In verschiedenen Ausführungsformen können allerdings vor dem Erhitzen noch weitere Prozessschritte durchgeführt werden, wie beispielsweise die Aufbringung einer dritten, vierten, etc. Zusammensetzung auf die Oberfläche, oder die Beschichtung der Rückseite des Substrats. In einer Ausführungsform kann das Erhitzen nach Auftragung der ersten metallhaltigen Zusammensetzung und vor Auftragung der zweiten metallhaltigen Zusammensetzung erfolgen. In diesem Fall erfolgt die Auftragung der zweiten metallhaltigen Zusammensetzung üblicherweise nicht mittels Aufdrucken, sondern mittels Gasphasenabscheidung, insbesondere PVD.

Die Aufbringung der ersten Zusammensetzung kann punktuell erfolgen. Dabei werden vergleichsweise kleine Teilbereiche der Oberfläche mit der ersten Zusammensetzung beschichtet. Diese Teilbereiche können abhängig von der Art der Auftragung eine beliebige Form haben, d.h. beispielsweise kreisförmig, rechteckig, vieleckig oder quadratisch sein. Der Durchmesser bzw. die Kantenlänger der derart beschichteten Bereiche kann im Bereich von etwa 30- 1000 µm, vorzugsweise 50 - 200 µm liegen. Die Zahl der Teilbereiche der Oberfläche auf die die erste metallhaltige Zusammensetzung aufgebracht wird ist mindestens zwei, kann aber auch wesentlich höher liegen. So ist es beispielsweise möglich, dass abhängig von der Substratgröße bis zu mehreren Zehntausend Teilbereichen entsprechend beschichtet werden. Auf handelsüblichen Solarzellen beträgt die Zahl der derart beschichteten Teilbereiche für die Emitterseite der Solarzelle etwa 1000 *-* 5000 und für die Rückseite der Solarzelle etwa 10000 - 200000. Der Abstand zwischen den Teilbereichen kann beliebig groß gewählt werden, ist aber üblicherweise größer als der größte Durchmesser bzw. die Kantenlänge des beschichteten Bereiches. Beispielsweise kann der Abstand 50 µm bis 5 mm betragen. Die Bereiche können in Form eines Punktgitters beschichtet werden.

Die zweite metallhaltige Zusammensetzung kann streifenförmig und/oder ganzflächig auf die Passivierungsschicht aufgebracht werden. Die Breite der Streifen kann dabei 50 - 200 µm, vorzugsweise 100 - 120 µm betragen. Die Breite wird üblicherweise so gewählt, dass der elektrische Widerstand möglichst gering, aber auch die durch den Streifen abgedeckte Fläche möglichst klein ist. Die aufgebrachten Streifen verbinden erfindungsgemäß mindestens zwei der beabstandeten Teilbereiche, die mit der ersten Zusammensetzung beschichtet sind. In verschiedenen Ausführungsformen verbinden diese Streifen mindestens 10, vorzugsweise mindestens 25, noch bevorzugter mindestens 50 mit der ersten metallhaltigen Zusammensetzung beschichtete Teilbereiche. Die zweite metallhaltige Zusammensetzung kann zusätzlich auch derart aufgebracht werden, dass die Streifen, die die Teilbereiche, die mit der ersten metallhaltigen Zusammensetzung beschichtet sind, durch weitere Streifen miteinander verbunden werden. Diese Streifen können wiederum durch weitere Streifen verbunden sein. Das Aufbringen der zweiten metallhaltigen Zusammensetzung erfüllt den Zweck den elektrischen Strom von der Oberfläche abzuleiten.

Das streifenförmige Aufbringen der zweiten metallhaltigen Zusammensetzung ist insbesondere für die Vorderseite einer Solarzelle bevorzugt, da so möglichst wenig der Fläche der Solarzelle abgedeckt wird.

Alternativ kann die zweite metallhaltige Zusammensetzung aber auch flächig, insbesondere ganzflächig, auf die gesamte Oberfläche des Substrats aufgebracht werden. Dabei ist es möglich, Aussparungen, beispielsweise für Lötpads, zu lassen. Die zweite metallhaltige Zusammensetzung kann dabei über die erste metallhaltige Zusammensetzung hinweg aufgebracht werden. Eine solche ganzflächige Aufbringung ist insbesondere für die Rückseite von Solarzellen möglich.

Die erste metallhaltige Zusammensetzung und/oder die zweite metallhaltige Zusammensetzung können auf die Oberfläche der dielektrischen Schicht aufgedruckt werden. Geeignete Verfahren sind im Stand der Technik bekannt und schließen beispielsweise Siebdruck- oder Tintenstrahldruckverfahren, Extrusionsverfahren, Stempeldruckverfahren, Tampondruckverfahren oder berührungsloses Verfahren ein. Vorzugsweise erfolgt die Aufbringung mittels Siebdruck.

Alternativ kann die Aufbringung der zweiten metallhaltigen Zusammensetzung aber auch durch Gasphasenabscheidung, beispielsweise PVD oder CVD erfolgen. Die chemische Gasphasenabscheidung kann plasmaunterstützt sein. PVD umfasst ist aber nicht beschränkt auf thermisches Verdampfen, Elektronenstrahl-Verdampfen, Laser-Verdampfen, Lichtbogen-Verdampfen, Molekularstrahlepitaxie, Sputtern, Ionenplattieren, und ICB Technik (ICBD).

Die Zusammensetzungen können in einer für die gewählte Art der Aufbringung geeigneten Form vorliegen. So liegen diese für Siebdruckverfahren üblicherweise als Paste vor. Andere Formen sind Gele, Lösungen oder Kolloide, beispielsweise Suspensionen oder Emulsionen.

Um die metallhaltigen Zusammensetzungen in die gewünschte Form zu bringen, können diese geeignete Bindemittel und/oder Lösungsmittels enthalten. Solche sind im Stand der Technik bekannt und umfassen verschiedene organische Polymere und organische Lösungsmittel.

Für die Gasphasenabscheidung liegen die Zusammensetzungen üblicherweise in Form der elementaren Metalle vor und enthalten keine weiteren Hilfsstoffe.

Die Metalle in den zwei metallhaltigen Zusammensetzungen können gleich oder unterschiedlich sein und können ausgewählt werden aus der Gruppe bestehend aus Silber, Kupfer, Aluminium, Gold, Wolfram, Vanadium, Nickel, Cobalt, Ruthenium, Rhodium, Palladium, Zinn und deren Legierungen oder Salzen davon. Das Metall ist vorzugsweise Silber oder ein Silbersalz. Die metallhaltigen Zusammensetzungen können ferner mit einem weiteren Element, vorzugsweise einem Metall, dotiert sein. Das Dotierungsmittel kann beispielsweise Bor oder Phosphor sein.

Die erste metallhaltige Zusammensetzung enthält vorzugsweise Silber oder Aluminium oder ein Silbersalz oder Aluminiumsalz. Die zweite metallhaltige Zusammensetzung kann, abhängig davon ob sie auf der Vorder- oder der Rückseite einer Solarzelle eingesetzt wird, vorzugsweise Silber oder ein Silbersalz bzw. Aluminium oder ein Aluminiumsalz enthalten.

Die erste metallhaltige Zusammensetzung enthält zusätzlich ein Ätzmittel, wie oben definiert. Die zweite metallhaltige Zusammensetzung enthält vorzugsweise kein Ätzmittel, d.h. keinen Bestandteil, der beim Erhitzen die dielektrische Schicht zerstört.

Als erste metallhaltige Zusammensetzung können im Stand der Technik bekannte Metallpasten, wie beispielsweise die in der EP 1687831 B1 erwähnten Pasten oder die von DuPont unter dem Markennamen Solamet® vertriebenen Pasten, wie beispielsweise Solamet® PVD2A, oder die von Heraeus unter dem Namen SOL-9235H angebotene Paste. Weitere geeignete Pasten sind dem Fachmann bekannt und kommerziell erhältlich.

Als zweite metallhaltige Zusammensetzung eignen sich die bekannten Pasten ohne das üblicherweise enthaltene Ätzmittel.

Falls die zweite metallhaltige Zusammensetzung mittels Gasphasenabscheidung auf die Oberfläche aufgebracht wird, kann die zweite metallhaltige Zusammensetzung ein elementares Metall, ein Metallsalz oder eine Mischung von Metallen, Metallsalzen oder beiden sein.

Bei dem Substrat mit der dielektrischen Oberflächenschicht kann es sich um eine Solarzelle handeln. Die dielektrische Schicht ist dann üblicherweise die Passivierungs- und Antireflexionsschicht der Vorderseite der Solarzelle, die aus Siliziumoxid, Siliziumcarbid, Siliziumnitrid, Titanoxid, Magnesiumfluorid oder Mischungen davon besteht, oder die Passivierungsschicht der Rückseite der Solarzelle, die aus Siliziumoxid, Siliziumcarbid, Siliziumnitrid, Aluminiumoxid oder anderen Metalloxiden oder Halbmetalloxiden sowie Mischungen davon besteht. Bei der unter der dielektrischen Schicht der Vorderseite liegenden Leiter- oder Halbleiterschicht handelt es sich üblicherweise um einen Emitter. Im Fall einer Silizium-Solarzelle vom n-Typ ist der Emitter p-dotiertes Silizium im Fall ein Solarzelle vom p-Typ n-dotiertes Silizium. Bei der unter der dielektrischen Schicht der Rückseite liegenden Leiter- oder Halbleiterschicht handelt es sich um eine Silizium-Basisschicht.

Zwischen den Schritten des Aufbringens der ersten und der zweiten metallhaltigen Zusammensetzung kann ferner noch ein Trocknungsschritt der ersten metallhaltigen Zusammensetzung erfolgen. Unabhängig davon kann nach dem Aufbringen der zweiten metallhaltigen Verbindung und vor dem Erhitzen noch ein weiterer Trocknungsschritt oder weitere Schritte des Aufbringens von anderen Zusammensetzungen erfolgen. Bei den weiteren Zusammensetzungen, die aufgebracht werden kann es sich beispielsweise um Lötpasten handeln.

In verschiedenen Ausführungsformen der Erfindung kann die Auftragung der ersten und/oder der zweiten metallhaltigen Zusammensetzung jeweils mehrfach erfolgen, beispielsweise zwei-, drei, vier- oder fünfmal, wobei zwischen den einzelnen Auftragungsschritten Trocknungsschritte liegen können. Das bedeutet, dass beispielsweise die erste metallhaltige Zusammensetzung zwei-, drei, vier- oder fünfmal hintereinander auf dieselben Bereiche der Oberfläche aufgebracht wird, wobei zwischen den einzelnen Auftragungsschritten eine Trocknung erfolgen kann. Analog kann eine solche mehrfache Auftragung für die zweite metallhaltige Zusammensetzung erfolgen.

Das Trocknen kann bei erhöhter Temperatur in einem Ofen oder durch Lufttrocknung erfolgen. Um ein vorzeitiges Durchfeuern der metallhaltigen Zusammensetzungen zu vermeiden beträgt die Temperatur bei dem Trocknungsschritt vorzugsweise weniger als 450°C.

Die Verfahren der Erfindung können in ein bestehendes Verfahren zur Herstellung von Solarzellen integriert werden. In diesen Verfahren wird die Solarzelle mittels bekannter Verfahren hergestellt bis zur Ausbildung einer Siliziumnitrid-Passivierungsschicht auf der Vorderseite und einer dielektrisch passivierenden Schicht auf der Rückseite.

In verschiedenen Ausführungsformen der Erfindung werden die Aufbringung der Leiterstrukturen auf die Vorder- und Rückseite der Solarzelle kombiniert. Dazu kann für die Vorderseite, für die Rückseite oder beide ein Verfahren gemäß der Erfindung verwendet werden. In solchen Ausführungsformen kann die erste metallhaltige Zusammensetzung für die Vorderseite und für die Rückseite gleich oder unterschiedlich sein. Analog kann auch die zweite metallhaltige Zusammensetzung für die Vorderseite und für die Rückseite gleich oder unterschiedlich sein. Es ist ebenfalls möglich, dass sowohl erste als auch zweite metallhaltige Zusammensetzung für Vorder- und Rückseite gleich oder unterschiedlich sind. In solchen Verfahren kann das Erhitzen nach Aufbringung einer metallhaltigen Zusammensetzung auf eine Seite erfolgen und ggf. nach jedem Auftragungsschritt weiterer metallhaltiger Zusammensetzungen auf eine der Oberflächen wiederholt werden oder das Erhitzen kann nach Auftragung aller metallhaltigen Zusammensetzungen, d.h. mindestens zwei auf die Vorderseite und mindestens zwei auf die Rückseite, erfolgen. Zwischen den einzelnen Auftragungsschritten können hierbei Trocknungsschritte liegen. Beispielsweise kann das Erhitzen nach Auftragung beider metallhaltiger Zusammensetzungen auf die Vorderseite und dann erneut nach Auftragung einer oder beider metallhaltiger Zusammensetzungen auf die Rückseite oder in umgekehrter Reihenfolge erfolgen. Das Erhitzen kann in verschiedenen Ausführungsformen vor der Auftragung der zweiten metallhaltigen Zusammensetzung auf die Rückseite erfolgen, wobei die zweite metallhaltige Zusammensetzung dann in einem separaten Schritt mittels PVD Verfahren aufgebracht werden kann..

In verschiedenen Ausführungsformen der Erfindung ist das Aufdampfen der zweiten metallhaltigen Zusammensetzung auf die Rückseite nach dem Erhitzen der ersten metallhaltigen Zusammensetzung auf der Rückseite und optional der metallhaltigen Zusammensetzungen auf der Vorderseite bevorzugt. Die aufgedampfte Metallschicht auf der Rückseite zeichnet sich gegenüber einer eingebrannten Paste durch eine bessere NIR-IR Reflektion aus. Das Aufdampfen erfolgt vorzugsweise ganzflächig.

In verschiedenen Ausführungsformen der Erfindung können alternativ nacheinander folgende Prozessschritte durchgeführt werden:
Alternative 1: (i) Aufdruck von lötfähigen Pads (silberhaltig) auf die Rückseite, (ii) Trocknen, (iii) Aufdrucken der ersten metallhaltigen Zusammensetzung (Al-haltig) auf die Rückseite; (iv) Trocknen, (v) Aufdrucken der zweiten metallhaltigen Zusammensetzung mit Aussparungen für die lötfähigen Pads auf die Rückseite, (vi) Trocknen, (vii) Aufdrucken der ersten metallhaltigen Zusammensetzung auf die Vorderseite, (viii) optional Trocknen, (ix) Aufdrucken der zweiten metallhaltigen Zusammensetzung auf die Vorderseite, und (x) Erhitzen.
Alternative 2: (i) Aufdrucken der ersten metallhaltigen Zusammensetzung (Al-haltig) auf die Rückseite; (ii) Trocknen, (iii) Aufdrucken der ersten metallhaltigen Zusammensetzung auf die Vorderseite, (iv) optional Trocknen, (v) Aufdrucken der zweiten metallhaltigen Zusammensetzung auf die Vorderseite, (vi) Erhitzen, (vii), ganzflächiges Aufdampfen oder Aufdampfen mit Aussparungen der zweiten metallhaltigen Zusammensetzung auf die Rückseite und (viii) optional Aufbringen lötfähiger Strukturen auf Vorder- und/oder Rückseite.
Alternative 3: (i) Aufdrucken der ersten metallhaltigen Zusammensetzung (Al-haltig) auf die Rückseite; (ii) Trocknen, (iii) ganzflächiges Aufdrucken oder aufdrucken mit Aussparungen der zweiten metallhaltigen Zusammensetzung auf die Rückseite, (iv) Trocknen; (v) Aufdrucken der ersten metallhaltigen Zusammensetzung auf die Vorderseite, (vi) optional Trocknen, (vii) Aufdrucken der zweiten metallhaltigen Zusammensetzung auf die Vorderseite, (viii) Erhitzen, (ix) optional Aufbringen lötfähiger Strukturen auf Vorder- und/oder Rückseite.

Optional kann nach dem Erhitzen und optional Aufdampfen und vor dem Aufbringen lötfähiger Strukturen ein Formiergas-Alneal Schritt, beispielsweise mit 95 % Stickstoff und 5 % Wasserstoff, erfolgen. Dieser Alneal Schritt kann auch zusammen mit dem Erhitzen erfolgen, wobei in einem solchen Fall die Temperaturprofile angepasst werden können.

Die elektrisch leitfähigen Kontaktstrukturen der Erfindung umfassen die nach dem Erhitzen ausgebildeten elektrischen Leitungen und Kontakte sowie das Substrat. Üblicherweise bilden diese einen Bestandteil einer Solarzelle. Die Solarzelle kann wiederum Bestandteil eines Solarmoduls sein, in welchem die einzelnen Solarzellen elektrisch miteinander verschaltet sind.

Ein mittels des Verfahrens der Erfindung behandeltes Substrat ist schematisch in Fig. 1 dargestellt. Diese Ausführungsform dient nur der Veranschaulichung der Erfindung ohne diese in irgendeiner Weise zu beschränken. Die Figur zeigt schematisch den Aufbau einer Solarzelle mit einer Basisschicht (103), der darüber liegenden Emitter-Schicht (102) und der zuoberst liegenden Antireflexions- und Passivierungsschicht (101). Auf die Antireflexionsschicht ist punktuell die erste metallhaltige Zusammensetzung (104) und streifenförmig die zweite metallhaltige Zusammensetzung (105) aufgebracht, wobei die zweite metallhaltige Zusammensetzung derart aufgebracht ist, dass sie die Bereiche auf die die erste metallhaltige Zusammensetzung aufgebracht ist, verbindet. Die Figur zeigt schematisch einen Ausschnitt der Oberfläche in einem Stadium, in welchem die zweite metallhaltige Zusammensetzung erst teilweise aufgebracht ist.

Ein weiteres mittels des Verfahrens der Erfindung behandeltes Substrat, bei dem es sich um eine Solarzelle, deren Rückseite beschichtet wird, handelt, ist schematisch in Figur 2 dargestellt. Die Figur zeigt schematisch den Aufbau einer Solarzelle mit einer Siliziumschicht mit Emitter (201), der darüber liegenden Antireflexions- und Passivierungsschicht (202) und der Rückseitenpassivierungsschicht (203). Auf die Rückseitenpassivierungsschicht wird punktuell die erste metallhaltige Zusammensetzung (204) und ganzflächig die zweite metallhaltige Zusammensetzung (205) aufgebracht. Schließlich können noch optional Pads aus einer lötfähigen, vorzugsweise silberhaltigen Paste (206) aufgebracht werden. Die Figur zeigt schematisch einen Ausschnitt der Oberfläche.

Weitere Ausführungsformen sind in den Ansprüchen und den Beispielen enthalten. Die folgenden Beispiele dienen der Veranschaulichung der Erfindung, wobei die Erfindung nicht auf diese speziellen Ausführungsformen beschränkt ist.

### Beispiele

### Beispiel 1:

1.) Voraussetzung ist ein p-Typ Silizium (2 Ohmcm Material) Wafer mit einem n-typ Phosphor Emitter (55 Ohm/sq), texturierter und antireflexbeschichteter (z.B. ~100 nm SiN, Brechungsindex 2,1) Emitteroberfläche und passivierter Rückseite.
2.) Aluminium Siebdruck der punktuellen Strukturen mit frittenhaltiger Paste auf die passivierte Rückseite (benutztes Sieb z.B. Meshbreite 300 µm)
3.) Trocknerschritt im Durchlaufofen z.B. 3 Zonen (320°C, 370°C, 400°C, Kettengeschwindigkeit 3 m/min)
4.) Ag Rückseitenpad Siebdruck (Paste mit geringem Aluminium Anteil)
5.) Trocknerschritt im Durchlaufofen z.B. 3 Zonen (320°C, 370°C, 400°C, Kettengeschwindigkeit 3 m/min)
6.) Aluminium Siebdruck ganzflächig (mit Aussparungen für die Ag pads) mit frittenreduzierter Paste
7.) Trocknerschritt im Durchlaufofen z.B. 3 Zonen (320°C, 370°C, 400°C, Kettengeschwindigkeit 3 m/min)
8.) Flipstation um die Solarzelle zu drehen
9.) Ag Siebdruck der punktuellen Strukturen mit frittenhaltiger Paste auf der Vorderseite entlang einer Fingerstruktur sowie entlang der späteren BusBar Bereiche
10.) Trocknerschritt im Durchlaufofen z.B. 3 Zonen (320°C, 370°C, 400°C, Kettengeschwindigkeit 3 m/min)
11.) Ag Siebdruck streifenförmig über die punktuellen Strukturen mit frittenreduzierter Paste
12.) Trocknerschritt im Durchlaufofen z.B. 3 Zonen (320°C, 370°C, 400°C, Kettengeschwindigkeit 3 m/min)
13.) CoFeuern (5 Zonen Durchlaufofen mit z.B. 250°C, 300°C, 600°C, 850°C, 860°C und Kettengeschwindigkeit 6 m/min)
14.) Evtl. Formiergas Alnealing (95 % N2 5 % H2 für 5 min bei 400°C)

Die Erfindung wird hierin durch Bezugnahme auf bestimmte Ausführungsformen beschrieben, ist aber nicht auf diese beschränkt. Insbesondere ist für den Fachmann ohne Weiteres ersichtlich, dass verschiedene Änderungen an der beschriebenen Erfindung vorgenommen werden können, ohne vom Sinn und Umfang der Erfindung, wie er durch die angefügten Patentansprüche bestimmt wird, abzuweichen. Der Umfang der Erfindung wird somit durch die Patentansprüche bestimmt und es ist beabsichtigt, dass die Erfindung alle Modifikationen und Änderungen, die in den Deutungs- und Äquivalenzbereich der Ansprüche fallen, umfasst.

## Patentansprüche

1. Verfahren zur Erzeugung von elektrisch leitfähigen Strukturen auf einem Substrat, das eine dielektrische Oberflächenschicht und eine darunter liegende elektrisch leitfähige Schicht aufweist, umfassend:
● Aufbringen einer ersten metallhaltigen Zusammensetzung, die ein Ätzmittel und ein Metall oder Metallsalz enthält, auf mindestens zwei voneinander beabstandete Teilbereiche der Oberfläche der dielektrischen Schicht;
● Aufbringen einer zweiten metallhaltigen Zusammensetzung, die ein Metall oder Metallsalz enthält, auf einen Teil der Oberfläche der dielektrischen Schicht, wobei die Aufbringung derart erfolgt, dass die zwei voneinander beabstandeten Teilbereiche der Oberfläche der dielektrischen Schicht, die mit der ersten metallhaltigen Zusammensetzung beschichtet sind, durch die zweite metallhaltige Zusammensetzung verbunden werden; wobei die die zweite metallhaltige Zusammensetzung kein Ätzmittel enthält.
● Erhitzen des Substrates um einen elektrischen Kontakt zwischen den elektrisch leitfähigen Strukturen und der elektrisch leitfähigen Schicht herzustellen, wobei das Erhitzen nach dem Aufbringen der ersten metallhaltigen Zusammensetzung, nach dem Aufbringen der ersten und zweiten metallhaltigen Zusammensetzung oder jeweils nach dem Aufbringen der ersten und nach dem Aufbringen der zweiten metallhaltigen Zusammensetzung erfolgt.

2. Verfahren nach Anspruch 1, wobei die erste metallhaltige Zusammensetzung punktuell auf die dielektrische Schicht aufgebracht wird.

3. Verfahren nach einem der Ansprüche 1-2, wobei die zweite metallhaltige Zusammensetzung streifenförmig oder ganzflächig auf die dielektrische Schicht aufgebracht wird.

4. Verfahren nach einem der Ansprüche 1-3, wobei
das Aufbringen der ersten metallhaltigen Zusammensetzung und der zweiten metallhaltigen Zusammensetzung mittels Drucken erfolgt;

5. Verfahren nach einem der Ansprüche 1-3, wobei
das Aufbringen der ersten metallhaltigen Zusammensetzung mittels Drucken und das Aufbringen der zweiten metallhaltigen Zusammensetzung mittels Gasphasenabscheidung erfolgt.

6. Verfahren nach einem der Ansprüche 1-5, wobei nach dem Aufbringen der ersten und/oder zweiten metallhaltigen Zusammensetzung zusätzlich ein Trocknungsschritt durchgeführt wird.

7. Verfahren nach einem der Ansprüche 1-6, wobei die erste metallische Zusammensetzung weiterhin Dotierstoffe aufweist, die die Leitfähigkeit der leitfähigen Schicht im Bereich unter den Teilbereichen auf die die erste metallhaltige Zusammensetzung aufgebracht ist nach dem Erhitzen erhöhen.

8. Verfahren nach einem der Ansprüche 1-7, wobei das Ätzmittel der ersten metallhaltigen Zusammensetzung ausgewählt wird aus Glasfritte, NH₄F, NH₄HF₂, H₃PO₄, H₃PO₃, PCl₃, PCl₅, POCl₃, KOH, HF/HNO₃, HCl, Chlorverbindungen, Schwefelsäure und Mischungen davon.

9. Verfahren nach einem der Ansprüche 1-8, wobei die erste metallhaltige Zusammensetzung und/oder die zweite metallhaltige Zusammensetzung ein Metall ausgewählt aus der Gruppe bestehend aus Silber, Kupfer, Aluminium, Gold, Wolfram, Nickel, Vanadium, Chrom, Cobalt, Ruthenium, Rhodium, Palladium, Zinn und deren Legierungen oder ein Salz davon enthält.

10. Verfahren nach Anspruch 9, wobei
(1) die erste und zweite metallhaltige Zusammensetzung Silber enthalten; oder
(2) die erste metallhaltige Zusammensetzung Silber und die zweite metallhaltige Zusammensetzung Aluminium enthält.

11. Verfahren nach einem der Ansprüche 1-10, wobei das Erhitzen des Substrats bei einer Temperatur von 500 bis 900 °C und/oder über einen Zeitraum von 1 bis 30 s erfolgt.

12. Verfahren nach einem der Ansprüche 1-11, wobei das Substrat eine Solarzelle ist.

13. Verfahren nach Anspruch 12, wobei
(1) die dielektrische Schicht eine Passivierungsschicht auf der Vorder- und/oder Rückseite der Solarzelle ist;
(2) die erste und die zweite metallhaltige Zusammensetzung jeweils sowohl auf die Vorder- als auch auf die Rückseite der Solarzelle aufgebracht werden, wobei sowohl erste als auch zweite metallhaltige Zusammensetzung für Vorder- und Rückseite gleich oder unterschiedlich sein können.

14. Elektrisch leitfähige Kontaktstrukturen, erhalten durch ein Verfahren gemäß einem der Ansprüche 1-13.

15. Solarzelle umfassend eine oder mehrere elektrisch leitfähige Kontaktstrukturen gemäß Anspruch 14.
